# EUROPEAN PATENT APPLICATION

(11) **EP 4 462 964 A1**
(43) Date of publication of application: **13.11.2024**
(21) Application number: 22918831.3
(22) Date of filing: 21.12.2022
(51) Int. Cl.: H05K 3/38, H05K 3/42

(54) **PRINTED WIRING BOARD AND METHOD FOR MANUFACTURING PRINTED WIRING BOARD**

(30) Priority: 04.01.2022 JP 2022000262
(71) Applicant: SUMITOMO ELECTRIC INDUSTRIES, LTD., Osaka-shi, Osaka 541-0041 (JP); Sumitomo Electric Printed Circuits, Inc., Koka-shi Shiga 528-0068 (JP)
(72) Inventor: MIYATA, Kazuhiro, Osaka-shi, Osaka 541-0041 (JP); NITTA, Koji, Osaka-shi, Osaka 541-0041 (JP); SAKAI, Shoichiro, Osaka-shi, Osaka 541-0041 (JP); KIYA, Satoshi, Koka-shi, Shiga 528-0068 (JP)
(74) Representative: Boult Wade Tennant LLP
(86) International application number: PCT/JP2022/047158
(87) International publication number: WO 2023/132247

(57) **Abstract**

A printed wiring board includes: a dielectric layer having a main surface; and a conductive pattern. The conductive pattern includes a metal layer that is disposed on the main surface, an electroless plating layer that is disposed on the metal layer, and an electrolytic plating layer that is disposed on the electroless plating layer. An average thickness of the metal layer is 2.1 µm or more and 9.0 µm or less. Maximum height roughness of a surface of the metal layer opposed to the main surface is 5.0 µm or less.

## Description

### TECHNICAL FIELD

The present disclosure relates to a printed wiring board and a method of manufacturing a printed wiring board. This application claims priority based on Japanese Patent Application No. 2022-000262 filed on January 4, 2022. The entire contents of the Japanese patent application are incorporated herein by reference.

### BACKGROUND ART

For example, Japanese Patent Laying-Open No. 2016-225524 (PTL 1) describes a printed wiring board. The printed wiring board described in PTL 1 includes a dielectric layer and a conductive pattern. The conductive pattern includes a seed layer that is disposed on a main surface of the dielectric layer, a first plating layer that is disposed on the seed layer, and a second plating layer that is disposed on the first plating layer. The average thickness of the seed layer is 2 µm or less.

### CITATION LIST

### PATENT LITERATURE

PTL 1: Japanese Patent Laying-Open No. 2016-225524

### SUMMARY OF INVENTION

A printed wiring board according to the present disclosure includes: a dielectric layer having a main surface; and a conductive pattern. The conductive pattern includes a metal layer that is disposed on the main surface, an electroless plating layer that is disposed on the metal layer, and an electrolytic plating layer that is disposed on the electroless plating layer. An average thickness of the metal layer is 2.1 µm or more and 9.0 µm or less. Maximum height roughness of a surface of the metal layer opposed to the main surface is 5.0 µm or less.

### BRIEF DESCRIPTION OF DRAWINGS

Fig. 1A is a cross-sectional view of a printed wiring board 100.
Fig. 1B is an enlarged view of IB in Fig. 1A.
Fig. 2 is a process chart of manufacturing printed wiring board 100.
Fig. 3 is a cross-sectional view describing preparation step S1.
Fig. 4 is a cross-sectional view describing first etching step S2.
Fig. 5 is a cross-sectional view describing hole making step S3.
Fig. 6 is a cross-sectional view describing electroless plating step S4.
Fig. 7 is a cross-sectional view describing resist pattern forming step S5.
Fig. 8 is a cross-sectional view describing electrolytic plating step S6.
Fig. 9 is a cross-sectional view describing resist pattern removing step S7.

### DETAILED DESCRIPTION

### [Problem to be Solved by the Present Disclosure]

In a method of manufacturing the printed wiring board described in PTL 1, first, a dielectric layer is prepared. A seed layer is disposed on a main surface of the dielectric layer. Second, a first plating layer is formed on the seed layer. Third, a resist pattern is formed on the first plating layer. The resist pattern has an opening from which the first plating layer is exposed. Fourth, a second plating layer is formed by electrolytic plating on the first plating layer exposed from the opening of the resist pattern. Fifth, the resist pattern is removed. Sixth, the first plating layer and the seed layer under the resist pattern are removed by etching. That is, the printed wiring board described in PTL 1 is formed by the semi-additive process.

Side-etching proceeds and sometimes forms a notch at the interface between the first plating layer and the second plating layer when the first plating layer and the seed layer under the resist pattern are removed. In the printed wiring board described in PTL 1, the average thickness of the seed layer is small (2 µm or less) and the distance between the notch described above and the dielectric layer is thus short. As a result, in the printed wiring board described in PTL 1, the transmission characteristics with respect to a high-frequency signal flowing in a conductive pattern sometimes deteriorate.

The present disclosure has been devised in view of the problem of the conventional technology as described above. More specifically, the present disclosure provides a printed wiring board that makes it possible to improve the transmission characteristics with respect to a high-frequency signal flowing in the conductive pattern.

### [Advantageous Effect of the Present Disclosure]

The printed wiring board according to the present disclosure makes it possible to improve the transmission characteristics with respect to a high-frequency signal flowing in the conductive pattern.

### [Description of Embodiment]

First, an embodiment of the present disclosure will be listed and described.
(1) A printed wiring board according to any of the embodiments includes: a dielectric layer having a main surface; and a conductive pattern. The conductive pattern includes a metal layer that is disposed on the main surface, an electroless plating layer that is disposed on the metal layer, and an electrolytic plating layer that is disposed on the electroless plating layer. An average thickness of the metal layer is 2.1 µm or more and 9.0 µm or less. Maximum height roughness of a surface of the metal layer opposed to the main surface is 5.0 µm or less.
   The printed wiring board according to (1) described above makes it possible to improve the transmission characteristics with respect to a high-frequency signal flowing in the conductive pattern.
(2) In the printed wiring board according to (1), the dielectric layer may be formed by using fluororesin including filler.
(3) In the printed wiring board according to (1) or (2), the metal layer may include copper or copper alloy.
(4) In the printed wiring board according to (1) to (3), a value obtained by dividing a width of an upper surface of the conductive pattern by a width of a bottom surface of the conductive pattern in a cross-sectional view orthogonal to a direction in which the conductive pattern extends may be 0.7 or more and 1.0 or less.
(5) In the printed wiring board according to (1) to (4), an average thickness of the conductive pattern may be 15 µm or more and 60 µm or less.
(6) A method of manufacturing a printed wiring board according to any of the embodiments includes: preparing a dielectric layer having a main surface and having a metal layer disposed on the main surface; decreasing a thickness of the metal layer by first etching; forming an electroless plating layer on the metal layer by electroless plating; forming, on the electroless plating layer, a resist pattern having an opening from which the electroless plating layer is exposed; forming an electrolytic plating layer by electrolytic plating on the electroless plating layer exposed from the opening; removing the resist pattern; and removing the electroless plating layer and the metal layer under the resist pattern by second etching. The first etching is performed to cause an average thickness of the metal layer to be 2.1 µm or more and 9.0 µm or less. Maximum height roughness of a surface of the metal layer opposed to the main surface is 5.0 µm or less.

The method of manufacturing the printed wiring board according to (6) makes it possible to obtain a printed wiring board in which the transmission characteristics are improved with respect to a high-frequency signal flowing in a conductive pattern.

### [Details of Embodiment of the Present Disclosure]

Next, with reference to the drawings, details of the embodiment of the present disclosure will be described. In the following drawings, the same or corresponding portions will be denoted by the same reference numerals and duplicate description will not be repeated. The printed wiring board according to the embodiment will be referred to as a printed wiring board 100.

### (Configuration of Printed Wiring Board 100)

The following describes a configuration of printed wiring board 100.

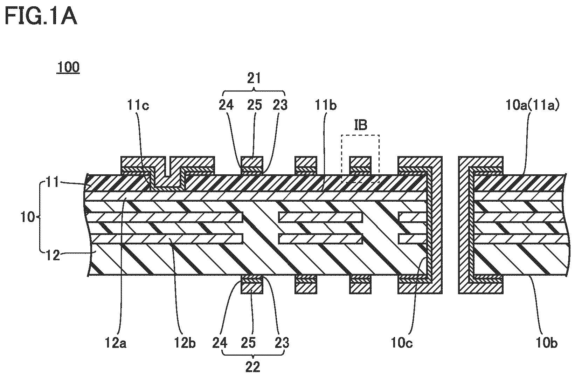

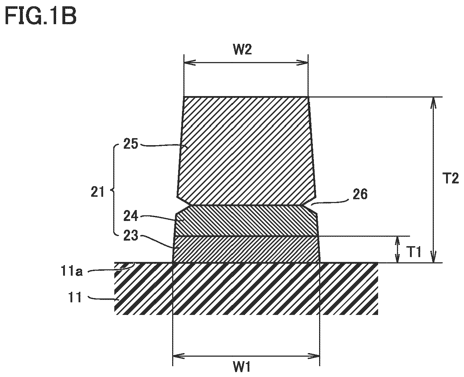

Fig. 1A is a cross-sectional view of printed wiring board 100. Fig. 1B is an enlarged view of IB in Fig. 1A. As illustrated in Figs. 1A and 1B, printed wiring board 100 includes a base material 10, and a conductive pattern 21 and a conductive pattern 22.

Base material 10 has a main surface 10a and a main surface 10b. Main surface 10a and main surface 10b are end faces of base material 10 in the thickness direction. Main surface 10b is the opposite surface to main surface 10a. A through hole 10c is formed in base material 10. Through hole 10c extends through base material 10 along the thickness direction.

Base material 10 includes a dielectric layer 11 and a substrate 12. Dielectric layer 11 is disposed above substrate 12. Dielectric layer 11 and substrate 12 are respectively included in main surface 10a and main surface 10b of base material 10. Substrate 12 is, for example, a rigid substrate. Substrate 12 may be, however, a flexible substrate. In addition, base material 10 does not have to include substrate 12 (may include dielectric layer 11 alone).

Dielectric layer 11 has a main surface 11a and a main surface 11b. Main surface 11a and main surface 11b are end faces of dielectric layer 11 in the thickness direction. Main surface 11a is included in main surface 10a. Main surface 11b is the opposite surface to main surface 11a and is opposed to substrate 12. A hole 11c is formed in dielectric layer 11. Hole 11c extends through dielectric layer 11 along the thickness direction. Conductive pattern 12a described below is exposed from hole 11c.

Dielectric layer 11 is a layer formed by using a dielectric. Dielectric layer 11 is formed by using, for example, fluororesin including filler. The fluororesin is, for example, polytetrafluoroethylene. The filler is formed by using, for example, silica.

The silica may be a natural product or a synthetic product. The silica may be crystalline silica or amorphous silica. In the case of a synthetic product, the silica may be formed by a dry process or a wet process. It is preferable from the perspectives of availability and quality that the silica be a synthetic product formed by a dry process.

The mass ratio of the filler to the fluororesin is obtained by dividing the mass of the filler included in dielectric layer 11 per unit volume by the mass of the fluororesin included in dielectric layer 11 per unit volume.

The mass ratio of the filler to the fluororesin is, for example, 1.3 or more. Setting the mass ratio of the filler to the fluororesin to 1.3 or more decreases the thermal expansion coefficient of dielectric layer 11 and improves the dimensional stability of dielectric layer 11. It is preferable that the mass ratio of the filler to the fluororesin be 1.5 or more. It is more preferable that the mass ratio of the filler to the fluororesin be 1.6 or more.

The mass ratio of the filler to the fluororesin is, for example, 2.2 or less. Setting the mass ratio of the filler to the fluororesin to 2.2 or less makes it possible to suppress decreases in handleability and peel strength caused by the embrittlement of dielectric layer 11. It is preferable that the mass ratio of the filler to the fluororesin be 2.0 or less.

The mass ratio of the filler to the fluororesin is measured by the following method. First, a cross-sectional image of dielectric layer 11 is acquired by using a scanning electron microscope (SEM). Second, EDX (Energy Dispersive X-ray spectroscopy) analyses are done at any 30 points on the acquired cross-sectional image, thereby obtaining the mass ratios between the filler composition atoms and the fluorine atoms at the respective points. Third, the mass ratio of the filler to the fluororesin is obtained by calculating the mass ratios between the filler and the fluororesin at the respective points based on the mass ratios between the filler composition atoms and the fluorine atoms and averaging the calculated mass ratios between the filler and the fluororesin with respect to the 30 points.

The average particle diameter of the filler is, for example, 0.3 µm or more. It is preferable that the average particle diameter of the filler be 0.5 µm or more. It is more preferable that the average particle diameter of the filler be 1.0 µm or more. The average particle diameter of the filler is, for example, 4.0 µm or less. Setting the average particle diameter of the filler to 4.0 µm or less makes it possible to secure the uniformity of the thickness of dielectric layer 11. It is preferable that the average particle diameter of the filler be 3.0 µm or less. It is more preferable that the average particle diameter of the filler be 2.0 µm or less. The average particle diameter of the filler is the particle diameter of a primary particle and is represented by the median diameter D50 of the particle size distribution. The average particle diameter of the filler is measured by using a particle diameter distribution measurement device (e.g., MT3300II of MicrotracBEL Corporation). Some types of fillers different from each other in average particle diameter may be used in combination as long as the average particle diameters fall within the range described above. It is preferable that the filler have a spherical shape to facilitate through hole 10c to be formed.

Dielectric layer 11 may further include fluororesin other than polytetrafluoroethylene. The amount of the fluororesin other than polytetrafluoroethylene contained in dielectric layer 11 is, for example, 10 wt% or less. The amount of the fluororesin other than polytetrafluoroethylene contained in dielectric layer 11 is preferably 5 wt% or less.

The filler may include filler formed by using a material other than silica in addition to the filler formed by using silica. Specific examples of the material other than silica include aluminum oxide, magnesium oxide, calcium oxide, talc, barium sulfate, boron nitride, zinc oxide, potassium titanate, glass, titanium oxide, mica, and the like.

The content rate (the value obtained by dividing the mass of the filler formed by using silica by the sum of the mass of the filler formed by using silica and the mass of the filler formed by using the material other than silica, and multiplying 100) of the filler formed by using silica is, for example, 60 wt% or more. It is preferable that the content rate of the filler formed by using silica be 70 wt% or more. It is more preferable that the content rate of the filler formed by using silica be 80 wt% or more.

The content rate of the filler formed by using silica is measured by the following method. First, a cross-sectional image of dielectric layer 11 is acquired by using an SEM. Second, EDX analyses are done on 50 fillers included in the acquired cross-sectional image to identify the composition of each of the fillers and the content rate of the filler formed by using silica is obtained based on the composition.

A liquid crystal polymer or polyphenylene ether may be used for dielectric layer 11 instead of the fluororesin. An olefin-based material such as polystyrene or polypropylene may be used for dielectric layer 11 instead of the fluororesin.

The relative dielectric constant of dielectric layer 11 is, for example, 2.0 or more and 4.0 or less. The relative dielectric constant of dielectric layer 11 is preferably 2.2 or more and 3.3 or less. The dielectric dissipation factor of dielectric layer 11 is, for example, 0.003 or less. It is preferable that the dielectric dissipation factor of dielectric layer 11 be 0.002 or less. It is more preferable that the dielectric dissipation factor of dielectric layer 11 be 0.0014 or less. The relative dielectric constant and the dielectric dissipation factor of dielectric layer 11 are measured under conditions of 25°C and 80 GHz on the basis of IPC TM-650 2.5.5.13 by using the split-cylinder resonator method.

Substrate 12 has conductive pattern 12a. Conductive pattern 12a is disposed on the main surface of substrate 12 including dielectric layer 11. Substrate 12 further has a conductive pattern 12b. Conductive pattern 12b is disposed inside substrate 12. It is to be noted that conductive pattern 12a and conductive pattern 12b are partially exposed from the inner wall surface of through hole 10c.

Conductive pattern 21 and conductive pattern 22 are respectively disposed on main surface 10a and main surface 10b. Conductive pattern 21 and conductive pattern 22 each include a metal layer 23, an electroless plating layer 24, and an electrolytic plating layer 25. A high-frequency signal flows in conductive pattern 21.

Metal layer 23 is disposed on each of the main surfaces (main surface 10a and main surface 10b) of base material 10. Metal layer 23 is formed by using, for example, copper. The purity of the copper in metal layer 23 is, for example, 99.5 wt% or more. It is preferable that the purity of the copper in metal layer 23 be 99.8 wt% or more. The purity of the copper in metal layer 23 is, for example, 99.999 wt% or less. Metal layer 23 may be formed by using copper alloy.

The front surface of metal layer 23 may be subjected to surface treatment. This surface treatment includes rustproofing treatment and treatment for improving the adhesiveness to dielectric layer 11. This surface treatment is performed by forming a layer including, for example, zinc, nickel, chromium, cobalt, molybdenum, silicon, or the like on the front surface of metal layer 23.

The average thickness of metal layer 23 disposed on dielectric layer 11 will be referred to as a thickness T1. Thickness T1 is 2.1 µm or more and 9.0 µm or less. Thickness T1 is measured by the following method. First, a cross-sectional image of metal layer 23 is acquired by using an SEM in any cross section orthogonal to the direction in which conductive pattern 21 extends. Second, the thickness of metal layer 23 is measured at any ten points on the cross-sectional image described above. Thickness T1 is obtained by calculating the average value of the measured values at these ten points.

The maximum height roughness of the surface of metal layer 23 opposed to main surface 10a is 5.0 µm or less. It is preferable that the maximum height roughness of the surface of metal layer 23 opposed to main surface 10a be 4.0 µm or less. It is more preferable that the maximum height roughness of the surface of metal layer 23 opposed to main surface 10a be 3.0 µm or less. The lower limit of the maximum height roughness of the surface of metal layer 23 opposed to main surface 10a is not limited in particular and may be, for example, about 0.3 µm.

The maximum height roughness of the surface of metal layer 23 opposed to dielectric layer 11 is measured by the following method. First, a cross-sectional image of the region near the interface with the dielectric layer 11 is acquired by using an SEM in any cross section orthogonal to the direction in which conductive pattern 21 extends. Second, the contour curve of the surface of metal layer 23 opposed to dielectric layer 11 is identified based on the cross-sectional image described above. Third, a method compliant with the JIS standards (JIS B 0601: 2013) is applied to the identified contour curve to calculate the maximum height roughness of the surface of metal layer 23 opposed to dielectric layer 11.

Although not illustrated, an adhesive layer may be interposed between each of the main surfaces (main surface 10a and main surface 10b) of base material 10 and metal layer 23. The adhesive layer is preferably formed by using fluororesin having a heat softening temperature of 320°C or less. A specific example of a constituent material of the adhesive layer includes perfluoroalkoxy alkane or a perfluoroethylene propene polymer.

Electroless plating layer 24 is disposed on metal layer 23. Electroless plating layer 24 is a layer formed by electroless plating. Electroless plating layer 24 is formed by using, for example, copper. Electrolytic plating layer 25 is disposed on electroless plating layer 24. Electrolytic plating layer 25 is a layer formed by electrolytic plating. Electrolytic plating layer 25 is formed by using, for example, copper.

Electroless plating layer 24 and electrolytic plating layer 25 are also formed on the inner wall surface of through hole 10c and the side surface of metal layer 23 continuous with the inner wall surface of through hole 10c. This electrically connects conductive pattern 21 and conductive pattern 22 to each other and also electrically connects conductive pattern 21 and conductive pattern 22 to conductive pattern 12a and conductive pattern 12b.

Electroless plating layer 24 and electrolytic plating layer 25 are also disposed on the inner wall surface of hole 11c, the side surface of metal layer 23 continuous with the inner wall surface of hole 11c, and conductive pattern 12a exposed from hole 11c. This electrically connects conductive pattern 21 to conductive pattern 12a.

The average thickness of conductive pattern 21 will be referred to as a thickness T2. Thickness T2 is, for example, 15 µm or more and 60 µm or less. Thickness T2 is measured by a method similar to that of thickness T1. It is to be noted that the average thickness of electroless plating layer 24 and the average thickness of electrolytic plating layer 25 included in conductive pattern 21 are respectively, for example, 0.05 µm or more and 0.8 µm or less and 12.85 µm or more and 50.2 µm or less.

The width of the bottom surface of conductive pattern 21 and the width of the upper surface of conductive pattern 21 in a cross-sectional view orthogonal to the direction in which conductive pattern 21 extends will be respectively referred to as width W1 and width W2. It is preferable that the value obtained by dividing width W2 by width W1 be 0.7 or more and 1.0 or less. It is to be noted that, as the value obtained by dividing width W2 by width W1 is closer to 1.0, the shape of conductive pattern 21 is closer to a rectangle (the rectangularity of the cross-sectional shape is higher) in the cross-sectional view orthogonal to the direction in which conductive pattern 21 extends.

Width W1 and width W2 are measured by the following method. First, cross-sectional images of conductive pattern 21 are acquired by using an SEM in any ten cross sections orthogonal to the direction in which conductive pattern 21 extends. Second, the width of the bottom surface of conductive pattern 21 and the width of the upper surface of conductive pattern 21 are measured in each of the cross-sectional images described above. Width W1 and width W2 are obtained by averaging these measured values with respect to the ten cross-sectional images.

### (Method of Manufacturing Printed Wiring Board 100)

The following describes a method of manufacturing printed wiring board 100.

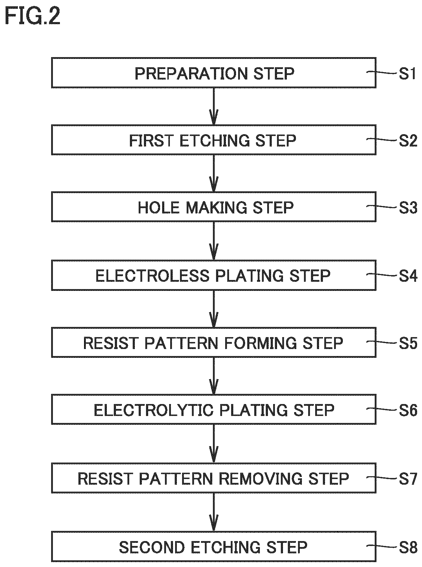

Fig. 2 is a process chart of manufacturing printed wiring board 100. As illustrated in Fig. 2, the method of manufacturing printed wiring board 100 includes preparation step S1, first etching step S2, hole making step S3, electroless plating step S4, resist pattern forming step S5, electrolytic plating step S6, resist pattern removing step S7, and second etching step S8. First etching step S2 is performed after preparation step S1. Hole making step S3 is performed after first etching step S2. Electroless plating step S4 is performed after hole making step S3. Resist pattern forming step S5 is performed after electroless plating step S4. Electrolytic plating step S6 is performed after resist pattern forming step S5. Resist pattern removing step S7 is performed after electrolytic plating step S6. Second etching step S8 is performed after resist pattern removing step S7.

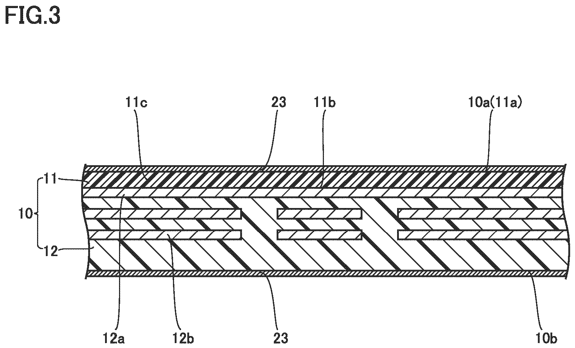

Fig. 3 is a cross-sectional view describing preparation step S1. As illustrated in Fig. 3, base material 10 is prepared in preparation step S1. It is to be noted that metal layer 23 is disposed on each of main surface 10a and main surface 10b of base material 10 prepared in preparation step S1.

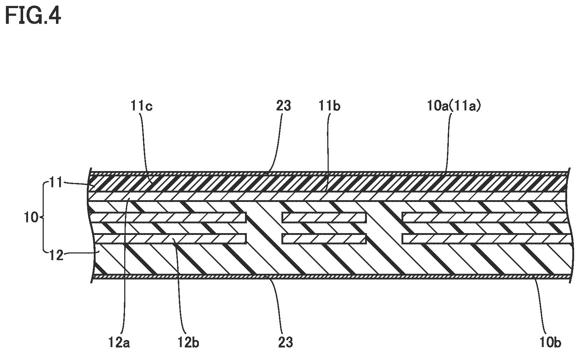

Fig. 4 is a cross-sectional view describing first etching step S2. As illustrated in Fig. 4, metal layer 23 is etched in first etching step S2. This etching is performed to cause thickness T1 to be 2.1 µm or more and 9.0 µm or less.

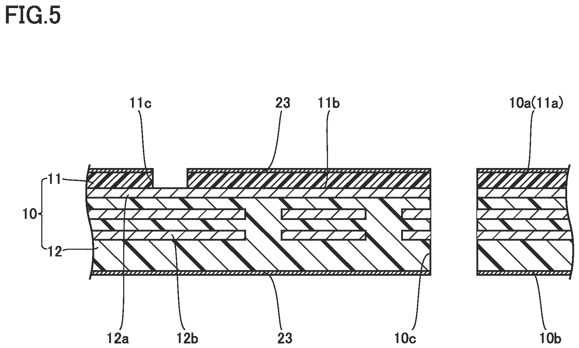

Fig. 5 is a cross-sectional view describing hole making step S3. As illustrated in Fig. 5, through hole 10c is formed in base material 10 and hole 11c is formed in dielectric layer 11 in hole making step S3. Through hole 10c and hole 11c are formed, for example, by drilling.

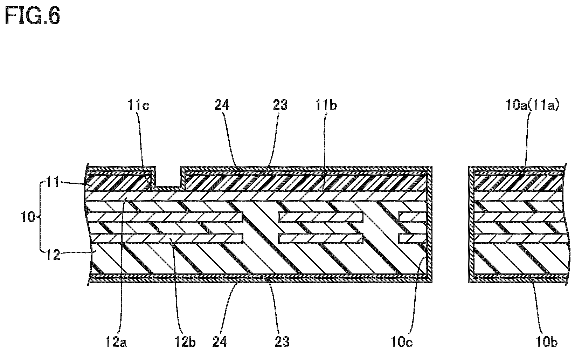

Fig. 6 is a cross-sectional view describing electroless plating step S4. As illustrated in Fig. 6, electroless plating layer 24 is formed on metal layer 23 by electroless plating in electroless plating step S4. At this time, electroless plating layer 24 is also formed on the inner wall surface of through hole 10c. In addition, at this time, electroless plating layer 24 is also formed on the inner wall surface of hole 11c and the side surface of metal layer 23 continuous with the inner wall surface of hole 11c.

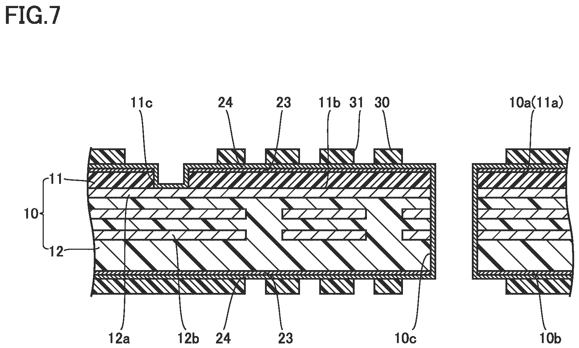

Fig. 7 is a cross-sectional view describing resist pattern forming step S5. As illustrated in Fig. 7, a resist pattern 30 is formed in resist pattern forming step S5. Resist pattern 30 has an opening 31. Opening 31 extends through resist pattern 30 along the thickness direction. Electroless plating layer 24 is exposed from opening 31.

In resist pattern forming step S5, first, dry film resist is bonded onto electroless plating layer 24. Second, exposure and development partially remove the dry film resist to make opening 31 and the portion of the dry film resist on which opening 31 is not formed serves as resist pattern 30.

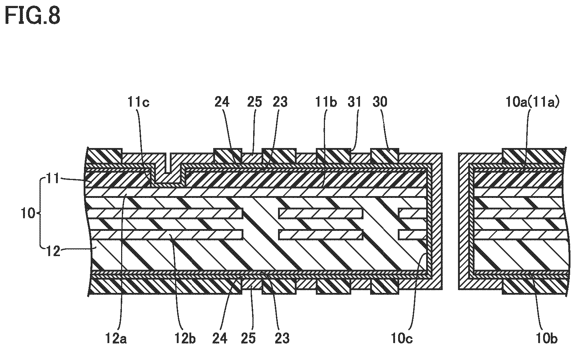

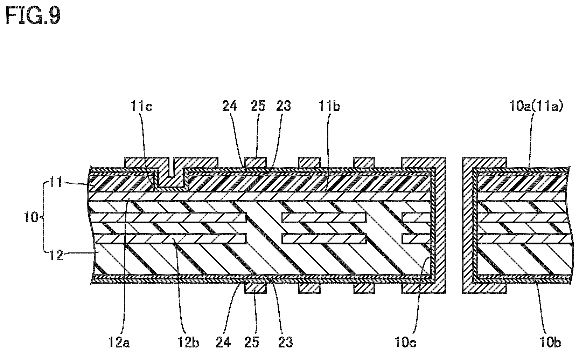

Fig. 8 is a cross-sectional view describing electrolytic plating step S6. As illustrated in Fig. 8, electrolytic plating layer 25 is formed by electrolytic plating on electroless plating layer 24 exposed from opening 31 in electrolytic plating step S6. Fig. 9 is a cross-sectional view describing resist pattern removing step S7. As illustrated in Fig. 9, resist pattern 30 is removed in resist pattern removing step S7.

Electroless plating layer 24 and metal layer 23 (exposed from the adjacent portions of electrolytic plating layer 25) under resist pattern 30 are removed by etching in second etching step S8. Printed wiring board 100 having the structure illustrated in each of Figs. 1A and 1B is thus manufactured.

It is to be noted that an etching solution used for second etching step S8 is preferably selected to control the rate of etching by a reaction between a reactive species in the etching solution and an etching target instead of the dispersion of the reactive species in the etching solution to the region near the etching target. More specifically, it is preferable to use an etching solution having a dissolution reaction rate of 2.0 µm/minute or less for the constituent materials (i.e., copper) of electroless plating layer 24 and metal layer 23 as the etching solution used for second etching step S8.

### (Advantageous Effect of Printed Wiring Board 100)

The following describes an advantageous effect of printed wiring board 100.

When the maximum height roughness of the surface of metal layer 23 opposed to main surface 10a is large, etching for a longer time is necessary in second etching step S8 to remove metal layer 23 under resist pattern 30. Therefore, when the maximum height roughness of the surface of metal layer 23 opposed to main surface 10a is large, the width (cross-sectional area) of conductive pattern 21 varies from place to place and the cross-sectional rectangularity of conductive pattern 21 decreases, and the transmission characteristics of conductive pattern 21 in which a high-frequency signal flows deteriorate.

In addition, when the maximum height roughness of the surface of metal layer 23 opposed to main surface 10a is large, the skin effect makes it difficult for a high-frequency signal to linearly flow, thereby deteriorating the transmission characteristics of conductive pattern 21 in which a high-frequency signal flows.

In printed wiring board 100, the maximum height roughness of the surface of metal layer 23 opposed to main surface 10a is 5.0 µm or less. Thus, according to printed wiring board 100, the time necessary for second etching step S8 is shortened, and the width (cross-sectional area) of conductive pattern 21 varies less and the cross-sectional rectangularity of conductive pattern 21 increases. In addition, in printed wiring board 100, the maximum height roughness of the surface of metal layer 23 opposed to main surface 10a is 5.0 µm or less and it is thus easy for a high-frequency signal to linearly flow.

In general, a current that flows in a signal line flows while being coupled to a ground circuit across a dielectric. It is thus easier for a current to flow on the front surface of the bottom of the signal line and the front surface of the side of the signal line close to the bottom of the signal line. As the current that flows in the signal line has a higher frequency, such a phenomenon is more likely to occur due to the skin effect. When the front surface of the side of the signal line close to the bottom of the signal line has a notch, the portion of the notch is recessed toward the inside of the signal line as compared with the other portions to weaken the electric field. As a result, it is difficult for a current to flow in the portion of the notch, the effective conductive volume decreases, and the increased conductor loss increases transmission loss. The skin effect described above increases the electric field of the front surface of the side of the signal line toward the bottom of the signal line. Thus, as the notch is disposed closer to the bottom of the signal line, the transmission loss increases.

Side-etching proceeding along the interface between electroless plating layer 24 and electrolytic plating layer 25 then sometimes forms a notch 26 in second etching step S8 (see Fig. 1B). When thickness T1 is small, notch 26 is closer to the bottom of conductive pattern 21. This deteriorates the transmission characteristics of conductive pattern 21 in which a high-frequency signal flows.

In contrast, when thickness T1 is too large, it takes a longer time to perform second etching step S8. This varies the width (cross-sectional area) of conductive pattern 21 more, decreases the cross-sectional rectangularity of conductive pattern 21, and deteriorates the transmission characteristics of conductive pattern 21 in which a high-frequency signal flows.

In printed wiring board 100, thickness T1 is 2.1 µm or more and 9.0 µm or less and it is thus possible to suppress the width (cross-sectional area) of conductive pattern 21 varying more and the cross-sectional rectangularity of conductive pattern 21 decreasing while positioning notch 26 apart from dielectric layer 11.

As described above, according to printed wiring board 100 that satisfies the condition that the maximum height roughness of the surface of metal layer 23 opposed to main surface 10a is 5.0 µm or less and the condition that thickness T1 is 2.1 µm or more and 9.0 µm or less, the transmission characteristics of conductive pattern 21 are improved in which a high-frequency signal flows.

### (Examples)

It will be referred to as a condition 1 that the maximum height roughness of the surface of metal layer 23 opposed to main surface 10a is 5.0 µm or less. It will be referred to as a condition 2 that thickness T1 is 2.1 µm or more and 9.0 µm or less. To evaluate the influence of condition 1 and condition 2, a sample 1 to a sample 7 were prepared as models for simulations. The details of sample 1 to sample 7 are shown in Table 1.

It is to be noted that, although not shown in Table 1, the relative dielectric constants and the dielectric dissipation factors of dielectric layers 11 were respectively 3.0 and 0.001 in sample 1 to sample 7.

### [Table 1]

**Table 1**

| sample | maximum height roughness (µm) of surface of metal layer 23 opposed to main surface 10a | thickness T1 (µm) | transmission loss (dB) of conductive pattern 21 in which high-frequency signal flows |
|---|---|---|---|
| 1 | 3 | 2.5 | -2.692 |
| 2 | 3 | 4 | -2.690 |
| 3 | 3 | 6 | -2.691 |
| 4 | 3 | 9 | -2.697 |
| 5 | 3 | 2 | -2.705 |
| 6 | 3 | 10 | -2.710 |
| 7 | 6 | 2.5 | -2.723 |

In sample 1 to sample 4, the maximum height roughnesses of the surfaces of metal layers 23 opposed to main surfaces 10a were 3.0 µm. Thicknesses T1 in sample 1 to sample 4 were respectively 2.5 µm, 4.0 µm, 6.0 µm, and 9.0 µm. That is, sample 1 to sample 4 satisfied both condition 1 and condition 2.

In sample 5 and sample 6, the maximum height roughnesses of the surfaces of metal layers 23 opposed to main surfaces 10a were 3.0 µm. Thicknesses T1 in sample 5 and sample 6 were respectively 2.0 µm and 10 µm. That is, sample 5 and sample 6 satisfied condition 1, but did not satisfy condition 2.

In sample 7, the maximum height roughness of the surface of metal layer 23 opposed to main surface 10a was 6.0 µm. Thickness T1 in sample 7 was 2.5 µm. That is, sample 7 satisfied condition 2, but did not satisfy condition 1.

Microstrip circuit models were created for sample 1 to sample 7 by using Ansys HFSS made by IDAJ and the transmission losses per 100 mm at 75 GHz were evaluated. As the absolute value of transmission loss shown in Table 1 increases, the transmission loss of conductive pattern 21 in which a high-frequency signal flows increases.

In sample 1 to sample 4 that satisfied both condition 1 and condition 2, the absolute values of the transmission losses of conductive patterns 21 in which high-frequency signals flowed were less than 2.7. In contrast, in sample 5 to sample 7 that did not satisfy any of condition 1 and condition 2, the absolute values of the transmission losses of conductive patterns 21 in which high-frequency signals flowed were 2.7 or more. This comparison showed based on the simulations that the satisfaction of both condition 1 and condition 2 improved the transmission characteristics of conductive patterns 21 in which high-frequency signals flowed.

The embodiment disclosed herein should be understood as an example in all respects and should not be understood as being restrictive. The scope of the present invention is demonstrated by not the embodiment described above, but CLAIMS. The scope of the present invention is intended to embrace all the modifications within the meaning and range equivalent to CLAIMS.

### REFERENCE SIGNS LIST

10 Base material; 10a Main surface; 10b Main surface; 10c Through hole; 11 Dielectric layer; 11a Main surface; 11b Main surface; 11c Hole; 12 Substrate; 12a Conductive pattern; 12b Conductive pattern; 21 Conductive pattern; 22 Conductive pattern; 23 Metal layer; 24 Electroless plating layer; 25 Electrolytic plating layer; 26 Notch; 30 Resist pattern; 31 Opening; 100 Printed wiring board; S1 Preparation step; S2 First etching step; S3 Step; S4 Electroless plating step; S5 Resist pattern forming step; S6 Electrolytic plating step; S7 Resist pattern removing step; S8 Second etching step; T1 Thickness; T2 Thickness; W1 Width; W2 Width.

## Claims

1. A printed wiring board comprising:
a dielectric layer having a main surface; and
a conductive pattern, wherein
the conductive pattern includes a metal layer that is disposed on the main surface, an electroless plating layer that is disposed on the metal layer, and an electrolytic plating layer that is disposed on the electroless plating layer,
an average thickness of the metal layer is 2.1 µm or more and 9.0 µm or less, and
maximum height roughness of a surface of the metal layer opposed to the main surface is 5.0 µm or less.

2. The printed wiring board according to claim 1, wherein the dielectric layer is formed by using fluororesin including filler.

3. The printed wiring board according to claim 1 or 2, wherein the metal layer includes copper or copper alloy.

4. The printed wiring board according to any one of claims 1 to 3, wherein a value obtained by dividing a width of an upper surface of the conductive pattern by a width of a bottom surface of the conductive pattern in a cross-sectional view orthogonal to a direction in which the conductive pattern extends is 0.7 or more and 1.0 or less.

5. The printed wiring board according to any one of claims 1 to 4, wherein an average thickness of the conductive pattern is 15 µm or more and 60 µm or less.

6. A method of manufacturing a printed wiring board, the method comprising:
preparing a dielectric layer having a main surface, the dielectric layer having a metal layer disposed on the main surface;
decreasing a thickness of the metal layer by first etching;
forming an electroless plating layer on the metal layer by electroless plating;
forming a resist pattern on the electroless plating layer, the resist pattern having an opening from which the electroless plating layer is exposed;
forming an electrolytic plating layer by electrolytic plating on the electroless plating layer exposed from the opening;
removing the resist pattern; and
removing the electroless plating layer and the metal layer under the resist pattern by second etching, wherein
the first etching is performed to cause an average thickness of the metal layer to be 2.1 µm or more and 9.0 µm or less, and
maximum height roughness of a surface of the metal layer opposed to the main surface is 5.0 µm or less.
